# FASCICULE DE BREVET EUROPEEN

(11) **EP 3 501 031 B1**
(45) Date de publication et mention de la délivrance du brevet: **30.09.2020**
(21) Numéro de dépôt: 17746142.3
(22) Date de dépôt: 04.08.2017
(51) Int. Cl.: H01H 9/22, H05K 5/02

(54) **BOÎTIER À OUVERTURE SÉCURISÉE**
GEHÄUSE MIT SICHERER ÖFFNUNG
HOUSING WITH SECURE OPENING

(30) Priorité: 19.08.2016 FR 1657838
(43) Date de publication de la demande: 26.06.2019
(73) Titulaire: Sagemcom Energy & Telecom SAS, 92500 Rueil-Malmaison (FR)
(72) Inventeur: TEBOULLE, Henri, 92500 Rueil-Malmaison (FR)
(74) Mandataire: Lavialle, Bruno François Stéphane
(86) Numéro de dépôt international: PCT/EP2017/069862
(87) Numéro de publication internationale: WO 2018/033414

(56) Documents cités:
- FR-A1- 2 635 938
- US-A- 4 870 605
- US-A- 5 682 772

## Description

La présente invention concerne la sécurisation de boîtiers pourvus d'une alimentation électrique. L'alimentation électrique peut comprendre des moyens de raccordement à un réseau électrique ou une batterie incorporée aux boîtiers. Les boîtiers peuvent avoir des dimensions relativement petites ou au contraire grandes pour former des armoires.

Il est connu des boîtiers comprenant un caisson fermé par un capot et pourvu d'un dispositif de détection de présence du capot, le boîtier comportant une alimentation électrique à laquelle le dispositif de détection est relié. Classiquement, le dispositif de détection comprend un bouton poussoir relié à une unité d'alerte et actionné par une portion du capot lorsque le capot est en place sur le caisson. L'unité d'alerte peut ainsi déterminer en fonction de l'état du bouton poussoir si le capot est présent ou pas et donc détecter une ouverture non autorisée du capot. Cependant, ceci suppose que le dispositif de détection est alimenté sans interruption : en effet, en cas d'interruption de l'alimentation, l'unité d'alerte ne fonctionne plus. Le document US5682772 décrit un dispositif selon le préambule de la revendication 1.

Un but de l'invention est de fournir un moyen permettant la détection d'un retrait du capot en cas d'interruption de l'alimentation électrique du boîtier.

A cet effet, on prévoit, un boîtier comprenant un caisson fermé par un capot, un dispositif de détection de présence du capot et une alimentation électrique à laquelle le dispositif de détection est relié. Le dispositif de détection comprend un bouton poussoir en regard d'une portion du capot et un relais monostable ayant un noyau mobile entre une position rentrée vers laquelle le noyau est rappelé élastiquement et une position sortie vers laquelle le noyau est piloté par une unité de commande agencée pour détecter l'état du bouton poussoir. Une lame élastique est fixée à l'extrémité du noyau pour avoir une extrémité libre écartée du bouton poussoir lorsque le noyau est en position rentrée et en regard du bouton poussoir lorsque le noyau est en position sortie. Ladite portion du capot vient en appui contre la lame lorsque le capot est présent de manière que la lame est déformée et actionne le bouton poussoir, la lame comportant un relief pour coopérer avec ladite portion. La lame et ladite portion sont agencées de telle manière que, lorsque le capot est en position sur le caisson, ladite portion retient le noyau en position sortie quand le relais n'est plus alimenté et ne s'oppose pas à l'arrivée du noyau en position sortie et à l'actionnement du bouton poussoir par la lame quand le noyau est piloté vers sa position sortie depuis sa position rentrée.

Ainsi, lorsque survient une rupture d'alimentation et que le capot est ôté pendant que l'alimentation est interrompue, la portion du capot sort du renfoncement de la lame élastique et libère la lame élastique et donc le noyau qui est rappelé dans sa position rentrée de sorte que le bouton poussoir n'est plus activé. Si au rétablissement de l'alimentation le capot n'a pas été remis, l'unité de commande détecte que le bouton poussoir n'est pas activé, ce qui révèle l'ouverture du capot. L'unité de commande pilote la sortie du noyau : la lame élastique arrive en regard du bouton poussoir mais ne peut activer le bouton poussoir tant que le capot n'a pas été remis et que la portion du capot ne déforme pas la lame élastique. Si le capot a été remis préalablement au rétablissement de l'alimentation, l'unité de commande détecte dans un premier temps que le bouton poussoir n'est pas activé, révélant l'ouverture du capot, et pilote le noyau vers sa position sortie. La lame élastique arrive au contact de la portion du capot qui déforme la lame élastique provoquant l'activation du bouton poussoir. De la sorte, dans le premier cas, l'unité de commande va détecter qu'un retrait du capot est en cours et, dans le deuxième cas, l'unité de commande va détecter qu'un retrait du capot a eu lieu.

Avantageusement, le dispositif de détection comprend un capteur de position du noyau, ledit capteur étant relié à l'unité de commande qui est agencée pour comparer la position détectée et la position pilotée.

Ce capteur permet de s'assurer du bon fonctionnement du relais.

D'autres caractéristiques et avantages de l'invention ressortiront à la lecture de la description qui suit d'un mode de réalisation particulier non limitatif de l'invention.

Il sera fait référence aux dessins annexés, parmi lesquels :
- la figure 1 est une vue schématique générale en perspective d'un boîtier selon l'invention ;
- la figure 2 est une vue schématique de la zone de ce boîtier entourant le dispositif de détection, le capot étant présent ;
- la figure 3 est une vue analogue à la figure 2, le capot étant ôté ;
- la figure 4 est une vue schématique partielle d'un boîtier selon une variante de l'invention.

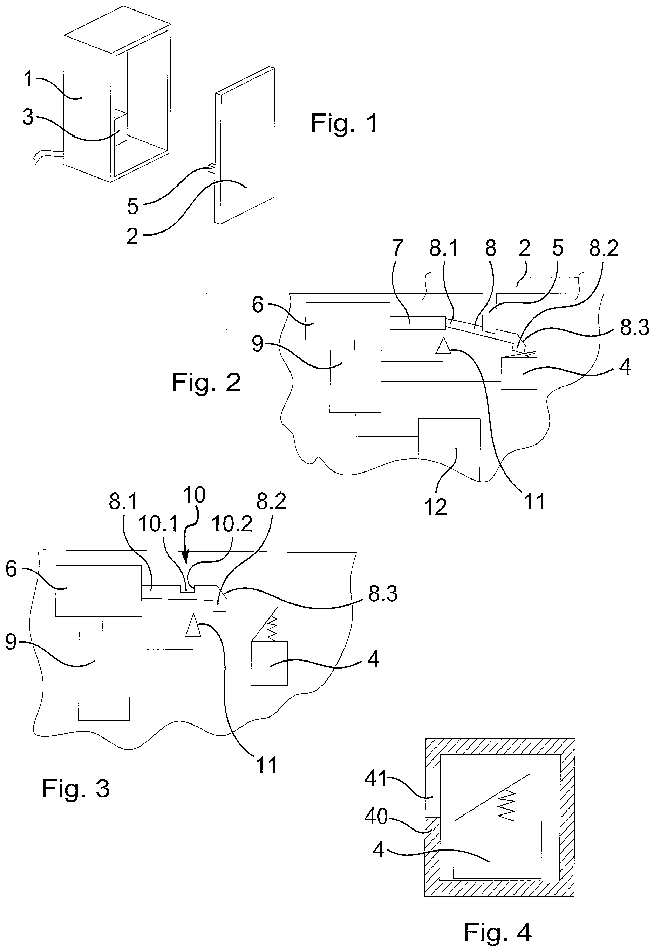

En référence aux figures 1 à 3, le boîtier selon l'invention comprend un caisson 1 fermé par un capot 2, un dispositif 3 de détection de présence du capot 2 et une alimentation électrique 12 à laquelle le dispositif de détection 3 est relié. Le capot 2 est ici amovible et maintenu en place sur le caisson 1 par un verrou non représenté. L'alimentation électrique 12 dont on ne voit sur la figure 1 qu'un câble de raccordement au réseau de distribution électrique comprend une unité de transformation, connue en elle-même, agencée pour transformer le courant du réseau de distribution en un ou plusieurs courants utilisables par les composants du boîtier.

Le dispositif de détection 3 comprend un bouton poussoir 4 et un relais monostable 6 ayant un noyau 7 à une extrémité de laquelle est fixée une extrémité 8.1 d'une lame élastique 8 s'étendant dans le prolongement du noyau 7. Le bouton poussoir 4 a un axe d'enfoncement parallèle à la direction de mise en place du capot 2 sur le caisson 1.

Le noyau 7 est mobile entre une position rentrée vers laquelle le noyau 7 est rappelé élastiquement et une position sortie vers laquelle le noyau 7 est piloté par une unité de commande 9. La lamelle élastique 8 a une extrémité libre écartée du bouton poussoir 4 lorsque le noyau 7 est en position rentrée et en regard du bouton poussoir 4 lorsque le noyau 7 est en position sortie. La lame élastique 8 est élastiquement déformable de telle manière que, lorsque le noyau 7 est en position sortie, la lame élastique 8 a à l'opposé de l'extrémité 8.1 une extrémité libre 8.2 :
- s'étendant au-dessus du bouton poussoir 4 quand la lame élastique 8 est dans un état de repos,
- enfonçant le bouton poussoir 4 quand la lame élastique 8 est dans un état de déformation.

Le fait que la lame élastique 8 soit dans son état de repos ou dans son état déformé dépend de la présence du capot 2 qui possède une portion 5 s'étendant entre le bouton poussoir 4 et l'extrémité libre 8.2 de la lame élastique 8 lorsque le noyau 7 est en position rentrée. Lorsque le capot 2 est présent et le noyau 7 est en position sortie, la portion 5 vient appuyer sur le dos de la lame élastique 8 et provoque sa déformation. L'extrémité libre 8.2 de la lame élastique 8 est pourvue d'un biseau 8.3 de telle manière que, lorsque le capot 2 est en place sur le caisson 1 et que le noyau 7 est amené de sa position rentrée à sa position sortie, le biseau 8.3 va venir au contact de la portion 5 et glisser contre ladite portion 5 provoquant la déformation de la lame élastique 8 dont l'extrémité libre 8.2 va venir enfoncer le bouton poussoir 4.

Le dos de la lame élastique 8 comprend un renfoncement 10 destiné à accueillir l'extrémité de la portion 5. Le renfoncement 10 comprend un fond 10.1 sur lequel appuie l'extrémité de la portion 5 et, du côté de l'extrémité libre 8.2 de la lame élastique 8, un flanc 10.2 formant un angle légèrement aigu avec le fond 10.1 et contre lequel s'appuie une surface sensiblement verticale de la portion 5, ladite surface étant orientée à l'opposé du relais monostable 6. On comprend que cet agencement permet à la portion 5 de retenir la lame élastique 8 dans un sens axial en s'opposant à l'effort de rappel du noyau 7 vers sa position rentrée : la portion 5 constitue alors un moyen de retenue du noyau 7 en position sortie.

L'unité de commande 9 est également reliée au bouton poussoir 4 et à l'alimentation électrique 12. L'unité de commande 9 comprend un processeur et une mémoire pour exécuter un programme de pilotage et est agencée pour détecter l'état du bouton poussoir 4, piloter le relais monostable 6 et émettre une alerte lorsque la capot a été retiré. L'unité de commande peut comprendre des moyens de télécommunication, comme des moyens d'émission/réception par courant porteur en ligne ou des moyens d'émission/réception sans fil par exemple de type GSM, pour transmettre l'alerte à un centre de traitement des alertes qui pourrait demander l'envoi d'un technicien sur place pour vérifier l'installation suite à la détection d'ouverture du capot. Le dispositif de détection comprend en outre un capteur 11 de position du noyau 7, ledit capteur étant relié à l'unité de commande 9.

Ainsi, lorsque le boîtier est normalement alimenté, l'unité de commande 9 pilote le noyau 7 en position sortie et vérifie via le capteur de position 11 que le noyau 7 est bien dans sa position sortie (dans le cas contraire, il émet une alerte de défaillance). En l'absence du capot 2, le bouton poussoir 4 n'est pas enfoncé et l'unité de commande 9 détecte l'absence du capot 2 et émet une alerte en conséquence. En présence du capot 2, le bouton poussoir 4 est enfoncé et l'unité de commande 9 détecte la présence du capot 2 de sorte que tout est nominal.

Lorsque le boîtier n'est plus alimenté et que le capot 2 n'est pas ouvert, la portion 5 retient la lamelle 8 et donc le noyau 7 en position sortie de sorte que le bouton poussoir 4 reste enfoncé. A la remise de l'alimentation, l'unité de commande 9 détecte l'enfoncement du bouton poussoir 4 de sorte que tout est nominal.

Lorsque le boîtier n'est plus alimenté et que le capot 2 est ôté pendant que l'alimentation est interrompue, la portion 5 du capot 2 sort du renfoncement 10 de la lame élastique 8 et libère la lame élastique 8 et donc le noyau 7 qui est rappelé dans sa position rentrée.

Si au rétablissement de l'alimentation le capot 2 n'a pas été remis, le bouton poussoir 4 n'est pas enfoncé et l'unité de commande 9 détecte l'absence du capot 2 et émet une alerte en conséquence. L'unité de commande 9 pilote ensuite la sortie du noyau 7 : l'extrémité libre 8.2 de la lame élastique 8 arrive en regard du bouton poussoir 4 mais ne peut activer le bouton poussoir 4 du fait de l'absence du capot 2. L'unité de commande vérifie via le capteur de position 11 que le noyau 7 est bien dans sa position sortie. Si la position sortie du noyau 7 est confirmée, l'unité de commande 9 n'émet pas un message de défaillance du relais. Lorsque le capot 2 est remis, la portion 5 du capot 2 appuie sur le fond 10.1 du renfoncement 10 ménagé sur le dos de la lame élastique 8 et déforme la lame élastique 8 qui vient enfoncer le bouton poussoir 4.

Si le capot a été remis préalablement au rétablissement de l'alimentation, l'unité de commande 9 détecte, dès sa mise sous tension, que le bouton poussoir 4 n'est pas activé, révélant l'ouverture du capot 2, et émet une alerte d'ouverture du capot 2 puis pilote le noyau 7 vers sa position sortie. Le biseau 8.3 de la lame élastique 8 arrive au contact de la portion 5 du capot 2 qui déforme la lame élastique 8 provoquant l'appui de l'extrémité libre 8.2 sur le bouton poussoir 4 et donc l'activation du bouton poussoir 4.

Dans la variante de la figure 4, le bouton poussoir 4 est enfermé dans un conteneur 40 comportant une ouverture 41 ayant des dimensions légèrement supérieures aux dimensions transversales de la lame élastique 8 pour laisser passer l'extrémité libre 8.2 de la lame élastique 8 et ne pas gêner sa déformation.

Bien entendu, l'invention n'est pas limitée au mode de réalisation décrit mais englobe toute variante entrant de le champ de l'invention telle que définie par les revendications.

En particulier :
- bien que le capot ait été décrit comme amovible, le capot peut être articulé sur le caisson pour former une porte ;
- bien que le capot ait été décrit comme maintenu en place par un verrou, le boîtier peut comprendre des moyens différents pour la fixation du capot sur le boîtier et par exemple des vis ;
- bien que le dispositif de détection ait été décrit avec un capteur de position du noyau 7, ce capteur est facultatif ;
- bien que la lame élastique 8 ait été décrite avec un renfoncement 10, elle peut avoir un relief en creux ou en saillie, par exemple une dent comportant une face inclinée comme le biseau 8.3 et une face verticale ayant la même fonction que le flanc 10.2 ;
- la lamelle déformable 8 peut être déformable sur toute sa longueur, une partie de celle-ci ou uniquement au niveau de sa jonction au noyau 7 ;
- un détecteur de la position rentrée du noyau 7 est avantageux car il permet de révéler une fraude dans le cas où l'unité de commande détecte à la fois que le bouton poussoir 4 est activé et que le noyau 7 est en position rentrée. En effet, dans le cas où un fraudeur irait bloquer dans l'état actif le bouton poussoir par quelque moyen que ce soit après avoir ouvert le capot 2, puis l'avoir refermé, alors que le noyau est vu en position rentrée par le capteur, un message d'alerte est émis, indiquant une tentative de fraude sur l'équipement. En effet, dans ce cas, sans le capteur qui permet de détecter l'anomalie correspondant à un bouton poussoir activé alors que le noyau 7 est en position rentrée, on croirait à tort que tout est nominal ;
- l'alimentation peut provenir du réseau électrique et/ou d'une batterie rechargeable ou non ;
- l'invention s'applique par exemple à des boîtiers d'équipements électroniques, des armoires électriques...

## Revendications

1. Boîtier comprenant un caisson (1) fermé par un capot (2), un dispositif (3) de détection de présence du capot (2) et une alimentation électrique (12) à laquelle le dispositif de détection (3) est relié, **caractérisé en ce que** le dispositif de détection (3) comprend un bouton poussoir (4) en regard d'une portion du capot, et un relais monostable (6) ayant un noyau (7) mobile entre une position rentrée vers laquelle le noyau (7) est rappelé élastiquement et une position sortie vers laquelle le noyau (7) est piloté par une unité de commande (9) agencée pour détecter l'état du bouton poussoir (4), une lame élastique (8) étant fixée à l'extrémité du noyau pour avoir une extrémité libre écartée du bouton poussoir (4) lorsque le noyau (7) est en position rentrée et en regard du bouton poussoir (4) lorsque le noyau (7) est en position sortie, ladite portion du capot venant en appui contre la lame lorsque le capot est présent de manière que la lame est déformée et actionne le bouton poussoir (4), la lame comportant un relief pour coopérer avec ladite portion, la lame et ladite portion étant agencées de telle manière que, lorsque le capot est en position sur le caisson, ladite portion retient le noyau (7) en position sortie quand le relais n'est plus alimenté et ne s'oppose pas à l'arrivée du noyau en position sortie et à l'actionnement du bouton poussoir (4) par la lame quand le noyau (7) est piloté vers sa position sortie depuis sa position rentrée.

2. Boîtier selon la revendication 1, dans lequel le dispositif de détection (3) comprend un capteur de position (11) du noyau (7), ledit capteur étant relié à l'unité de commande (9) qui est agencée pour comparer la position détectée et la position pilotée.

3. Boîtier selon la revendication 1, dans lequel le bouton poussoir (4) est enfermé dans un conteneur comportant une ouverture ayant des dimensions légèrement supérieures aux dimensions transversales de la lame élastique (8).

## Patentansprüche

1. Gehäuse, umfassend einen Kasten (1), der von einer Abdeckung (2) verschlossen ist, eine Detektionsvorrichtung (3) zum Erfassen des Vorhandenseins der Abdeckung (2) und eine Stromversorgung (12), an die die Detektionsvorrichtung (3) angeschlossen ist, **dadurch gekennzeichnet, dass** die Detektionsvorrichtung (3) eine Drucktaste (4) gegenüber einem Abschnitt der Abdeckung umfasst, und ein monostabiles Relais (6), das einen Kern (7) hat, der zwischen einer zurückgezogenen Position, in die der Kern (7) elastisch rückgestellt wird, und einer ausgefahrenen Position beweglich ist, in die der Kern (7) von einer Steuereinheit (9) gesteuert wird, die ausgebildet ist, um den Zustand der Drucktaste (4) zu erfassen, wobei ein elastisches Blatt (8) am Ende des Kerns so befestigt ist, dass es ein freies Ende hat, das zu der Drucktaste (4) beabstandet ist, wenn der Kern (7) in der zurückgezogenen Position ist, und das gegenüber der Drucktaste (4) ist, wenn der Kern (7) in der ausgefahrenen Position ist, wobei der genannte Abschnitt der Abdeckung an dem Blatt zur Anlage kommt, wenn die Abdeckung vorhanden ist, sodass das Blatt verformt wird und die Drucktaste (4) betätigt, wobei das Blatt ein Reliefelement umfasst, um mit dem genannten Abschnitt zusammenzuwirken, wobei das Blatt und der genannte Abschnitt derart angeordnet sind, dass, wenn die Abdeckung in ihrer Position auf dem Kasten ist, der genannte Abschnitt den Kern (7) in der ausgefahrenen Position hält, wenn das Relais nicht mehr versorgt wird, und sich weder dem Ankommen des Kerns in der ausgefahrenen Position noch der Betätigung der Drucktaste (4) durch das Blatt widersetzt, wenn der Kern (7) von seiner zurückgezogenen Position in seine ausgefahrene Position gesteuert wird.

2. Gehäuse nach Anspruch 1, bei dem die Detektionsvorrichtung (3) einen Positionssensor (11) zur Positionserfassung des Kerns (7) umfasst, wobei der genannte Sensor mit der Steuereinheit (9) verbunden ist, die ausgebildet ist, um die erfasste Position mit der gesteuerten Position zu vergleichen.

3. Gehäuse nach Anspruch 1, bei dem die Drucktaste (4) in einem Behälter eingeschlossen ist, der eine Öffnung mit Abmessungen umfasst, die geringfügig größer als die Querabmessungen des elastischen Blattes (8) sind.

## Claims

1. A housing comprising a box (1) closed by a cover (2), a detector device (3) for detecting the presence of the cover (2), and an electrical power supply (12) to which the detector device (3) is connected, the housing being **characterized in that** the detector device (3) comprises a pushbutton (4) in register with a portion of the cover, and a monostable relay (6) having a core (7) that is movable between a retracted position towards which the core (7) is urged resiliently, and an extended position towards which the core (7) is driven by a control unit (9) arranged to detect the state of the pushbutton (4), a spring blade (8) being fastened to the end of the core so as to have a free end that is spaced apart from the pushbutton (4) when the core (7) is in the retracted position and that is in register with the pushbutton (4) when the core (7) is in the extended position, said portion of the cover coming to press against the blade when the cover is present so that the blade is deformed and actuates the pushbutton (4), the blade including a portion in relief for co-operating with said portion of the cover, the blade and said portion of the cover being arranged in such a manner that when the cover is in position on the box, said portion of the cover holds the core (7) in the extended position even when the relay is no longer powered and opposes neither the core reaching the extended position nor the pushbutton (4) being actuated by the blade when the core (7) is driven to its extended position from its retracted position.

2. The housing according to claim 1, wherein the detector device (3) comprises a position sensor (11) for sensing the position of the core (7), said sensor being connected to the control unit (9) which is arranged to compare the detected position and the driven position.

3. The housing according to claim 1, wherein the pushbutton (4) is enclosed in a container including an opening of dimensions that are slightly greater than the transverse dimensions of the spring blade (8).
